# EUROPEAN PATENT APPLICATION

(11) **EP 2 985 917 A1**
(43) Date of publication of application: **17.02.2016**
(21) Application number: 14189480.8
(22) Date of filing: 20.10.2014
(51) Int. Cl.: H03M 13/41

(54) **Decoding method and device**

(30) Priority: 15.08.2014 CN 201410403871
(71) Applicant: ALi Corporation, Hsinchu City 300 (TW)
(72) Inventor: Luo, Run-Shu, Zhuhai Guangdong 519080 (CN)
(74) Representative: Viering, Jentschura & Partner mbB Patent- und Rechtsanwälte

(57) **Abstract**

A decoding method is provided for a decoding device of a specific error-correction coding system. An encoding device of the specific error-correction coding system has m registers. An initial state of the m registers is set as the values of least m significant bits of control information. Steps of the decoding method are described as follows. The decoding device receives a symbol sequence output from the encoding device (FIG. 1, S101). A Viterbi algorithm is performed on the symbol sequence to generate a decoding sequence (FIG. 1, S103). Based on the decoding sequence, a path merit of a state corresponding to the decoding sequence is updated, and/or path merits of other states not corresponding to the decoding sequence are updated (FIG. 1, S105).

## Description

### BACKGROUND

### 1. Technical Field

The present disclosure relates to a decoding method and a decoding device; in particular, to a decoding method and a decoding device used in a receiver of a Digital Video Broadcasting-Satellite (DVB-S) system.

### 2. Description of Related Art

Digital Video Broadcasting-Satellite Second Generation (DVB-S2) and Digital Video Broadcasting-Satellite Second Generation Extension (DVB-S2X) are DVB-S transmission standards provided by European Telecommunications Standards Institute (ETSI). DVB-S2 and DVB-S2X are video broadcasting technologies which receive the video signals casted by satellites. Generally, the satellite transmits the video signal of a microwave from the terrestrial base station to the satellite television through a long distance. A user may use a direction antenna to receive the video signal, and the received video signal is decoded by a decoding device and then output to the satellite television. The video signal transmitted by the satellite is encoded, and thus the receiver must need a specific decoding device for playing the video signal successfully. However, the signal transmission of the satellite has a disadvantage that the signal is disturbed with ease when the weather is instable. Thus, to achieve high efficient data transmission, the transmitter for transmitting the video signal to the satellite television usually adopts a robust channel coding technology.

A convolution code is a widely used channel coding technology. In the electrical communication engineering field, the convolution code is an error-correction code. A convolution calculation is performed on an input original message and an impulse response of the encoding device to form the convolution code. During the processing proceeding, bits of the input original message are sequentially enter the registers of the encoding device from the input end, and that is, each of the registers stores one input bit. After each of the bits is processed, the bit in the register is input into the next register. Next, the bits of the encoded message are sequentially transmitted to the output end. Since the bits input original message are sequentially input into the registers of the encoding device, each batch of data associated with the convolution code is related to the past original message. Compared to the block code, the convolution code has a memory property for maintaining channel. In most decoding methods of the convolution code, a Viterbi algorithm is a widely used algorithm for decoding the convolution code.

The Viterbi algorithm is a dynamic scheduling algorithm for finding a path of a most possible observed event sequence (implying a state sequence) based on a maximum likelihood. However, since the initial state of register is set 0 during the convolution code encoding process, the probabilities of states are assumed to be equal to each other during the decoding process of the Viterbi algorithm, thus causing poor decoding efficiency.

### SUMMARY

An exemplary embodiment of the present disclosure provides a decoding method for a decoding device of a specific error-correction coding system, wherein an encoding device of the specific error-correction coding system has m registers, and an initial state of the m registers is set as the values of least m significant bits of control information. The decoding method may have steps as follows. A symbol sequence output from the encoding device is received. A Viterbi algorithm is performed on the symbol sequence to generate a decoding sequence. Based on the decoding sequence, a path merit of a state corresponding to the decoding sequence is updated, and/or path merits of other states not corresponding to the decoding sequence are updated.

An exemplary embodiment of the present disclosure provides a decoding device. The decoding device receives a symbol sequence output from an encoding device of a specific error-correction coding system, wherein the encoding device has m registers, and an initial state of the m registers is set as the values of least m significant bits of control information. The decoding method comprises one or multiple circuits configured for a Viterbi algorithm calculation module and a path merit assignment module. The Viterbi algorithm calculation module is used to perform a Viterbi algorithm on the symbol sequence to generate a decoding sequence. The path merit assignment module is used to update a path merit of a state corresponding to the decoding sequence based on the decoding sequence, and/or update path merits of other states not corresponding to the decoding sequence based on the decoding sequence.

To sum up, during the encoding process, the encoding device of the specific error-correction coding system sets the initial state of the registers thereof to be values of least significant bits of some control information, wherein the distribution of the control information most has a specific rule. Thus, the decoding method and decoding device of the exemplary embodiments of the present disclosure utilize the control information as the known message, such that the decoding device and the decoding method can obtain the distribution of the initial state based on the decoding result, and the probability of the initial state can be updated accordingly. Therefore, the decoding method and the decoding device can increase the decoding speed and decoding performance of the receiver.

In order to further understand the techniques, means and effects of the present disclosure, the following detailed descriptions and appended drawings are hereby referred, such that, through which, the purposes, features and aspects of the present disclosure can be thoroughly and concretely appreciated; however, the appended drawings are merely provided for reference and illustration, without any intention to be used for limiting the present disclosure.

### BRIEF DESCRIPTION OF THE DRAWINGS

The accompanying drawings are included to provide a further understanding of the present disclosure, and are incorporated in and constitute a part of this specification. The drawings illustrate exemplary embodiments of the present disclosure and, together with the description, serve to explain the principles of the present disclosure.
FIG. 1 is a flow chart of a decoding method according to an exemplary embodiment of the present disclosure.
FIG. 2 is a schematic diagram showing a frame structure according to an exemplary embodiment of the present disclosure.
FIG. 3 is a schematic diagram showing a tail biting convolution code encoder according to an exemplary embodiment of the present disclosure.
FIG. 4 is a block diagram of a decoding device according to an exemplary embodiment of the present disclosure.

### DESCRIPTION OF THE EXEMPLARY EMBODIMENTS

Reference will now be made in detail to the exemplary embodiments of the present disclosure, examples of which are illustrated in the accompanying drawings. Wherever possible, the same reference numbers are used in the drawings and the description to refer to the same or similar parts.

An exemplary embodiment of the present disclosure provides a decoding method and decoding device which are used to improve decoding performance of the receiver. The decoding method and the decoding device utilize the partial bits of the regularly distributed control information as the known information of the decoding end, so as to optimize the probabilities of the initial states for decoding. Thus, the necessary time of the iterations and feedbacks for decoding is reduced, the decoding speed is increased, and the decoding performance is improved.

The decoding method provided by an exemplary embodiment of the present disclosure can be adopted by the decoding device of any specific error-correction coding system. For example, the decoding device can be used in a receiver of the DVB-S system adopting DVB-S2 or DVB-S2X standard, and the specific error-correction code can be the convolution code. However, the present disclosure does not limit the specific error-correction code to be the convolution code.

When the specific error-correction code is the convolution code, the encoding device of the convolution code has m registers, and the initial state of the m register is set to be the values of the least significant bits of the control information. The control information may exist in the header of the frame, but the present disclosure however does not limit the existing location of the control information.

To put it concretely, in the wireless communication field, the data packet transmitted by the transmitter is assembled by a plurality of frames, and that is, the frame is the transmission unit of the frame, wherein the front portion of the frame is used as the header. The header mainly has the related control information. During the transmission, by using the control information of the header, the transmitter can indicate the receiver the related information which modulation mode the transmission data of the frame is used and to which server the frame is transmitted. In addition, since the encoding device outputs the data encoded by the convolution code, the decoding device can be correspondingly a Viterbi decoding device.

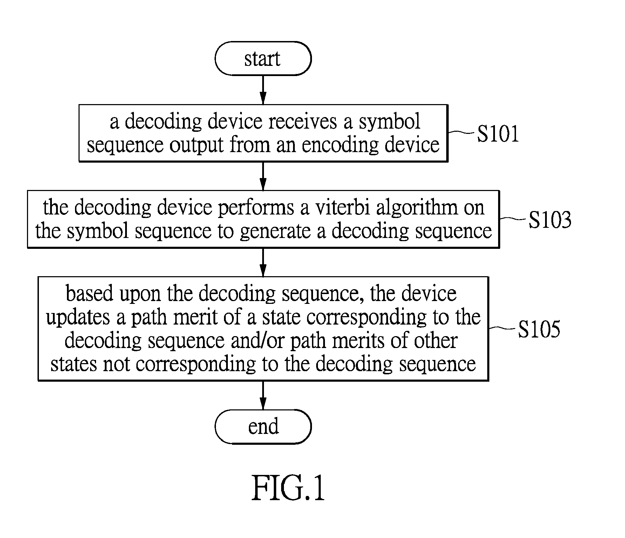

Referring to FIG. 1, FIG. 1 is a flow chart of a decoding method according to an exemplary embodiment of the present disclosure. Firstly, at step S101, the decoding device receives a symbol sequence output from an encoding device. Next, at step S103, the decoding device performs a Viterbi algorithm on the symbol sequence to generate a decoding sequence. Finally, at step S105, based on the decoding sequence, the decoding device updates a path merit of a state corresponding to the decoding sequence, and/or updates path merits of other states not corresponding to the decoding sequence.

To put it concretely, at step S101, the symbol sequence output from the encoding device is the data which the raw bit sequence is encoded by the convolution code. For example, if the raw bit sequence is information of α bits, the raw bit sequence is converted to encoded information of β bits after being encoded by the convolution code, and the value α/β is the code rate of the convolution code. The decoding device receives the symbol sequence output from the encoding device, that is, the information of the encoded β bits mentioned above.

Next, at step S103, the decoding device performs a Viterbi algorithm on the information of the encoded β bits for decoding the information of the raw α bits, and then generates a decoding sequence according to information of the decoded α bits. To present the generated decoding sequences as states of the decoding tree diagram, information of least significant m bits associated with the decoded α bits is extracted as the decoding sequence in practice.

For example, when the encoding device is a convolution code encoding device with four registers, the encoding tree diagram in the encoding process is presented as 16 states (State 0 through State 15) associated with four bits, and the 16 states are 0000, 0001, 0010, 0011, 0100, 0101, 0110, 0111, 1000, 1001, 1010, 1011, 1100, 1101, 1110, 1111. In the similar manner, when decoding device executes the Viterbi algorithm, the decoding tree diagram is as presented as 16 states (State 0 through State 15) associated with four bits. Thus, the information of least significant four bits associated with all bits decoded by the decoding device is extracted to find the corresponding state.

Simply, the corresponding state found based upon the decoding result in the previous decoding period is presented as the current value of the registers in the decoding device, and also as the initial state in the current decoding period. Thus, when the decoding device performs the Viterbi algorithm on the received symbol sequence in the current decoding period, the initial state in the current decoding period has been known in advance. Thus, the path merits of the states can be updated accordingly to facilitate to find the most possible path in the execution of the Viterbi algorithm. It is noted that, the person with ordinary skill in the art can design the generation manner of the decoding sequence based upon the practical requirement and or application, and the present disclosure does not limit the implementation for generating the decoding sequence.

At step S105, according to the decoding sequence, the decoding device updates the path merit of the state corresponding to the decoding sequence and/or the path merits of the other states not corresponding to the decoding sequence. The Viterbi algorithm uses the maximum likelihood for finding the path of the most possible observation event sequence. In other words, the Viterbi algorithm selects the path of the minimum path merit as the output decoding result. According to the decoding sequence generated by step S103, the step S105 can optimize and adjust the path merits of all states, so as to help the decoding device to accurately select the minimum path as the output decoding result, and to improve the decoding performance.

The detail implementation for adjusting the path merits of all states at step S105 can be merely decreasing the path merit of the state corresponding to the decoding sequence, merely increasing the path merits of the other states not corresponding to the decoding sequence, or decreasing the path merit of the state corresponding to the decoding sequence and increasing the path merits of the other states not corresponding to the decoding sequence simultaneously. That is, the spirit of step S105 is to update the path merit of each state according to the decoding sequence, such that the decoding path with the minimum path merit is optimized. By the way, the implementation of step S105 is not limited.

Furthermore, in the conventional Viterbi algorithm, each state has one probability for determining the path merit thereof. For example, the larger the probability of the state is (i.e. the more possible the state is selected), the lower the path merit of the state is. By contrast, the less the probability of the state is (i.e. the less possible the state is selected), the higher the path merit of the state is.

In the exemplary embodiment of the present disclosure, according to the generated decoding sequence, the decoding device can increase the probability of the state corresponding to the decoding sequence, and decrease the probabilities of the other states not corresponding to the decoding sequence. Then, the decoding device decreases the path merits of the states having the smaller probabilities, and increases the path merits of the states having the higher probabilities, so as to optimize the decoding path of the minimum path merit.

For example, assuming the encoding device is the convolution code encoding device with four registers, when the decoding device executes the Viterbi algorithm, the decoding tree diagram can be presented as 16 states State 0 through State 15 associated four bits. Thus, before the decoding device executes the Viterbi algorithm, the probabilities of the 16 states State 0 through State 15 are identical to each other, and that is the 16 states State 0 through State 15 have the identical path merits. For example, the probabilities of the 16 states State 0 through State 15 are 1/16 firstly, and the path merits of the 16 states State 0 through State 15 are set to be 0. After the first decoding period elapses, the decoding sequence from the decoding result corresponds to the state State 0 for example. This means the current values of the registers in the encoding device may be the four bits (0000) of the state State 0, and the initial state in the second encoding period is the four bits (0000) of the state State 0. Thus, the decoding device increase the probability of the state State 0 to be 2/17, and decreases the probabilities of the states State 1 through State 15 to be 1/17. Since the probability of the state State 0 is larger than the probabilities of the states State 1 through State 15, the state State 0 is tending to be selected. As mentioned above, the higher the probability of the state is, the smaller the path merit of the state is. Thus, the path merit of the state State 0 can be set to be 0, and the path merits of the states State 1 through State 15 can be set to be 1.

Next, after the second decoding period elapses, the decoding sequence from the decoding result corresponds to the state State 2 for example. This means the current values of the registers in the encoding device may be the four bits (0010) of the state State 2, and the initial state in the third encoding period is the four bits (0010) of the state State 2. The state State 2 is tending to be selected next, and thus the decoding device increases the probability of the State 2, and decreases the probabilities of the states State 0, State 1, State 3 through State 15. The decoding device for example sets the probabilities of the states State 0 and State 2 to be 2/18, and sets the probabilities of the states State 1 and State 3 through State 15 to be 1/18. Since the probabilities of the states State 0 and State 2 are larger than the probabilities of the states State 1 and State 3 through State 15, the states State 0 and State 2 are tending to be selected. As mentioned above, the higher the probability of the state is, the smaller the path merit of the state is. Thus, the path merits of the states State 0 and State 2 can be set to be 0, and the path merits of the states State 1 and State 3 through State 15 can be set to be 1.

Next, after the third decoding period elapses, the decoding sequence from the decoding result also corresponds to the state State 0 for example. This means the current values of the registers in the encoding device may be the four bits (0000) of the state State 0, and the initial state in the fourth encoding period is the four bits (0000) of the state State 0. The state State 0 is tending to be selected next, and thus the decoding device increases the probability of the State 0, and decreases the probabilities of the states State 1 through State 15. The decoding device for example sets the probability of the state State 0 to be 3/19, sets the probability of the state State 2 to be 2/19, and sets the probabilities of the states State 1 and State 3 through State 15 to be 1/19. Since the probability of the state State 0 is larger than the probabilities of the states State 1 through State 15, the state State 0 is tending to be selected. As mentioned above, the higher the probability of the state is, the smaller the path merit of the state is. Thus, the path merit of the state State 0 can be set to be 0, the path merit of the state State 2 can be set to be 1, and the path merits of the states State 1 through State 15 can be set to be 2.

It can be understood that the decoding method according to an exemplary embodiment of the present disclosure can update the probabilities and/or path merits of the states, so as to help the decoding device to select the correct path as the output decoding result, and thus the decoding performance is enhanced. Furthermore, the initial probabilities of the states are continuously optimized in the next decoding period, and the decoding speed is enhanced as well as the decoding performance. It is noted that the person with ordinary skill in the art can design the manner for updating the path merits and/or probabilities of the states in response to the practical requirement or application, and the present disclosure does not limit the manner for updating the path merits and/or probabilities of the states.

An example for illustrating how the decoding device of the DVB-S2X system executes the above mentioned decoding method is given as follows. However, the present disclosure is not limited to the following example. According to the DVB-S2X standard, the encoding device is a tail biting convolution code encoder.

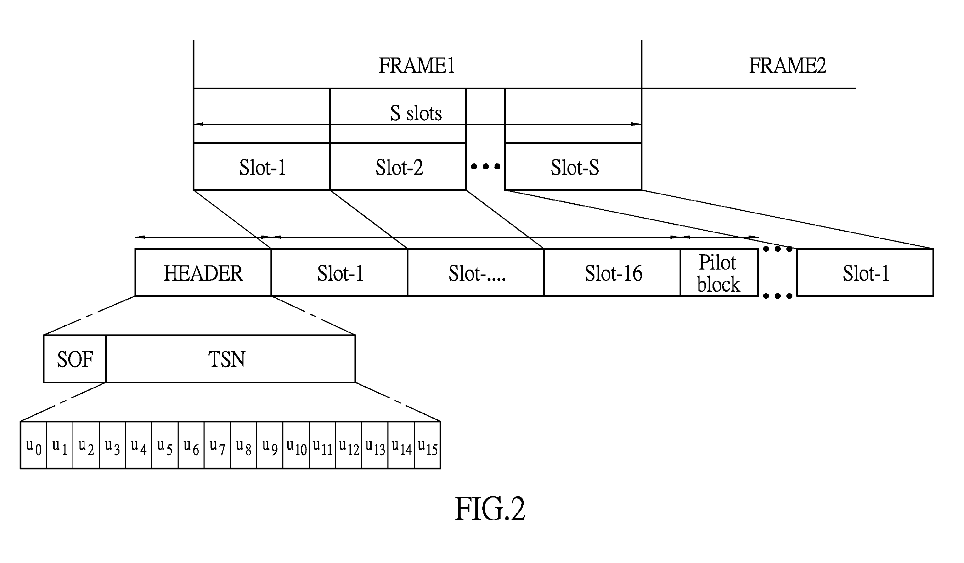

Referring to FIG. 2, FIG. 2 is a schematic diagram showing a frame structure according to an exemplary embodiment of the present disclosure. The control information TSN associated with the physic layer frame is located in the front header. The control information TSN can be presented by 16 bits u₀ through u₁₅. For example, according to the DVB-S2X standard, the front 7 bits u₀ through u₆ of the 16 bits associated with the control information TSN are used to indicate the encoding or modulation information, the back 8 bits u₈ through u₁₅ of the 16 bits associated with the control information TSN are used to avoid the Inter-Symbol Interference (ISI), and the middle one bit u₇ of the 16 bits associated with the control information TSN is used to indicate the frame type. It is noted that the design of the control information TSN is not used to limit the present disclosure. The person with ordinary skill in the art can design the control information TSN in the frame according to the practical requirement and application.

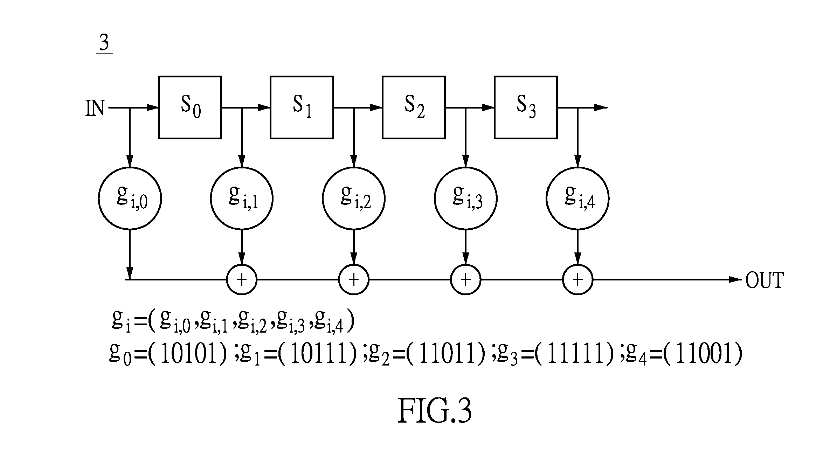

Referring to FIG. 2 and FIG. 3, FIG. 3 is a schematic diagram showing a tail biting convolution code encoder according to an exemplary embodiment of the present disclosure. The tail biting convolution code encoder 3 has four registers S₀ through S₃, and the initial state of the registers S₀ through S₃ are set to the values of the least significant four bits u₁₂, u₁₃, u₁₄, u₁₅ in the control information TSN, i.e. the registers S₀ through S₃ respectively store the bits u₁₅ through u₁₂. Next, the 16 bits u₀ through u₁₅ of the control information TSN are sequentially input to the registers S₀ through S₃ of the tail biting convolution code encoder 3 via the input end IN. Each of the registers S₀ through S₃ stores one bit for individual encoding calculation, and the encoded information is then sequentially transmitted to the output end OUT. Next, the bits stored in the registers S₀ through S₂ are output to the next registers S₁ through S₃, and the bit stored in the register S₃ is output to the output end OUT. Practically, the code rate of the tail biting convolution code encoder 3 can be 1/5, and thus after the 16 bits u₀ through u₁₅ of the control information TSN have been input, the tail biting convolution code encoder 3 encodes the 16 bits of the control information TSN to generate a symbol sequence with encoded 80 bits.

It is noted that, since the initial state of the registers S₀ through S₃ is set to be the values of the least four significant bits u₁₂ through u₁₅ of the control information TSN, the ending state of the registers S₀ through S₃ is also the values of least four significant bits u₁₂ through u₁₅ of the control information TSN after the 16 bits u₀ through u₁₅ of the control information TSN have been sequentially input to the tail biting convolution code encoder 3 for completing the encoding process. That is, the registers S₀ through S₃ respectively store the bits u₁₅ through u₁₂ after the encoding process is completed once, or the initial state of the registers S₀ through S₃ is the same as the ending state of the registers S₀ through S₃, which is set to be the values of the four bits u₁₂ through u₁₅.

Referring to FIG. 1 through FIG. 3, at step S101, the decoding device receives the symbol sequence with 80 bits output from the tail biting convolution code encoder 3. Next, at step S103, the decoding device performs a Viterbi algorithm on the symbol sequence with the encoded 80 bits for decoding, such that the 16 bits u₀ through u₁₅ of the control information TSN can be obtained. Among the least 16 bits u₀ through u₁₅ of the decoded control information TSN, the least significant four bits u₁₂ through u₁₅ are selected as the decoding sequence. At step S105, according to the decoding sequence, the decoding device can know the current values of the registers S₀ through S₃ of the encoding device. Thus, based upon the decoding sequence, the probabilities of the states can be updated. For example, the probability of the state corresponding to the decoding sequence is increased while the probabilities of the states not corresponding to the decoding sequence are decreased. Thus, optimizing the initial probabilities of the states in the next decoding period can enhance the decoding performance.

Since the control information is distributed with a specific rule, adopting the regularly distributed partial bits of the control information as the known message of the decoding device can not only optimize the initial probabilities of the state for decoding, but also decrease the time of iteration and feedback, such that the decoding speed is enhanced.

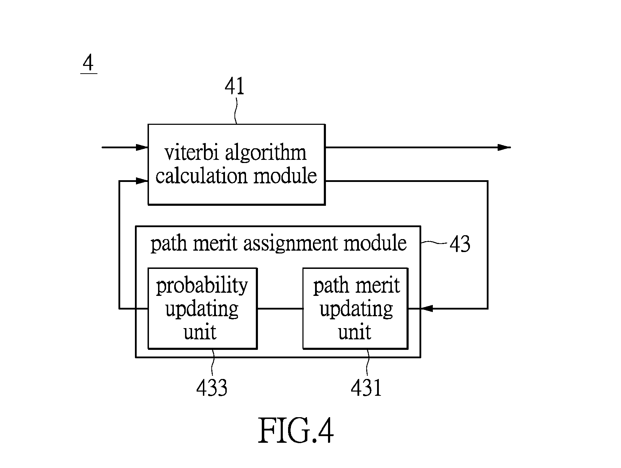

As mentioned above, the decoding method can be used in a decoding device of a specific error-correction coding system. To illustrate the operations of the decoding method, an exemplary embodiment of the present disclosure provides one implementation of the decoding device. Referring to FIG. 4, FIG. 4 is a block diagram of a decoding device according to an exemplary embodiment of the present disclosure. However, the decoding device 4 is one implementation, and the present disclosure is not limited thereto.

The decoding device 4 can be used in any specific error-correction coding system. For example, the decoding device 4 can be a DVB-S2X decoding device, the specific error-correction code can be the convolution code, but the present disclosure is not limited thereto. The decoding device 4 can comprises one or more circuits for configuring a Viterbi algorithm calculation module 41 and a path merit assignment module 43. The above components can be implemented by merely hardware circuit, or by incorporation of the hardware circuit and firmware or software. In short, the present disclosure does not limit the implementation of the decoding device 4.

The decoding device 4 receives a symbol sequence output from an encoding device, wherein the encoding device has m registers, and the initial state of the m registers is set to be the values of the least significant m bits of the control information. The encoding device for example can be the tail biting convolution code encoder 3 as shown in FIG. 3. The encoding device can have four registers, and the initial state of the four registers can be the least significant four bits of the control information in the front header of the PL frame based upon the DVB-S2X standard. Furthermore, the above example is not used to limit the present disclosure.

Referring to FIG.3 and FIG. 4, the symbol sequence output from the encoding device is the data which the raw bit sequence is encoded by the tail biting convolution code encoder 3. For example, the 16 bits of the control information is encoded by the tail biting convolution code encoder 3 to convert to the information of encoded 80 bits. Thus, the symbol sequence output from encoding device and firstly received by the decoding device 4 is the information of the encoded 80 bits output from the tail biting convolution code encoder 3.

Still referring to FIG. 4, the Viterbi algorithm calculation module 41 performs a Viterbi algorithm on the received symbol sequence to generate a decoding sequence. The path merit assignment module 43 updates the path merit of the state corresponding to the decoding sequence, and/or updates the path merits of the other state not corresponding to the decoding sequence.

To put it concretely, the decoding device 4 uses the Viterbi algorithm calculation module 41 to perform the Viterbi algorithm on the symbol sequence for decoding, so as to obtain the decoded raw bit sequence, and then a decoding sequence is generated according to the raw bit sequence. To present the generated decoding sequence as the states of the encoding and decoding tree diagrams, the least significant m bits of the decoded raw bit sequence are extracted as the decoding sequence.

For example, when the encoding device is the tail biting convolution code encoder 3 with four registers of FIG. 3, the encoding tree diagram during the encoding process can be presented as 16 states State 0 through State 15 associated with four bits, and the 16 states are respectively 0000, 0001, 0010, 0011, 0100, 0101, 0110, 0111, 1000, 1001, 1010, 1011, 1100, 1101, 1110, 1111. When the Viterbi algorithm calculation module 41 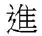 executes the Viterbi algorithm, the decoding tree diagram presents 16 states State 0 through State 15 by using four bits. Thus, the Viterbi algorithm calculation module 41 extracts the least significant four bits of the decoded raw bit sequence as the corresponding state. It is noted that the person with ordinary skill in the art can design the Viterbi algorithm calculation module 41 according to the actual requirement and application, and the present disclosure does not limit the implementation of the Viterbi algorithm calculation module 41.

In short, the state corresponding to the decoding result in the previous decoding period is the current values of the registers of the encoding device, and is the initial state in the current decoding period. When the Viterbi algorithm calculation module 41 performs the Viterbi algorithm on the symbol sequence in the current decoding period, the Viterbi algorithm calculation module 41 knows the initial state in the current encoding period in advance, and thus can update the path merits of the states accordingly, so as to help the execution of the Viterbi algorithm to find the possible path. It is noted that the person with ordinary skill in the art can design the decoding sequence according to the actual requirement and application, and the present disclosure does not limit the design of the decoding sequence.

Based upon the decoding sequence, the path merit assignment module 43 updates the path merit of the state corresponding to decoding sequence and/or the path merits of the other states not corresponding to the decoding sequence. In practice, he Viterbi algorithm uses the maximum likelihood for finding the path of the most possible observation event sequence. In other words, the Viterbi algorithm selects the path of the minimum path merit as the output decoding result. According to the decoding sequence generated from the Viterbi algorithm calculation module 41, the path merit assignment module 43 optimizes and adjusts the path merits of the states, so as to help the decoding device 4 to select the path of the minimum path merit as the output decoding result. Thus, the decoding performance is enhanced.

The manner that path merit assignment module 43 adjusts the path merits of the states can be merely decreasing the path merit of the state corresponding to the decoding sequence, increasing the path merits of the other states not corresponding to the decoding sequence, or decreasing the path merit of the state corresponding to the decoding sequence and increasing the path merits of the other states not corresponding to the decoding sequence simultaneously. However, the present disclosure is not limited to the above manner. The spirit of the path merit assignment module 43 is to update the path merit of each state according to the decoding sequence, such that the decoding path with the minimum path merit is optimized.

Furthermore, in the conventional Viterbi algorithm, each state has one probability for determining the path merit thereof. For example, the larger the probability of the state is (i.e. the more possible the state is selected), the lower the path merit of the state is. By contrast, the less the probability of the state is (i.e. the less possible the state is selected), the higher the path merit of the state is.

In the decoding device 4 of the exemplary embodiment of the present disclosure, the path merit assignment module 43 comprises a probability updating unit 431 and a path merit updating unit 433. The probability updating unit 431 can increase the probability of the decoding sequence according to the generated decoding sequence and decrease the probabilities of the other states based upon the decoding sequence. The path merit updating unit 433 decreases the path merit of the state with the higher probability and increases the path merit of the state with the less probability. Therefore, the decoding path of the minimum path merit is optimized. It is noted that the person with ordinary skill in the art can design the probability updating unit 431 and the path merit updating unit 433 based on the actual application and requirement, and the present disclosure does not limit the detailed implementations of the probability updating unit 431 and the path merit updating unit 433.

To sum up, during the encoding process, the encoding device of the specific error-correction coding system sets the initial state of the registers thereof to be values of least significant bits of some control information, wherein the distribution of the control information most has a specific rule. Thus, the decoding method and decoding device of the exemplary embodiments of the present disclosure utilize the control information as the known message, such that the decoding device and the decoding method can obtain the distribution of the initial state based on the decoding result, and the probability of the initial state can be updated accordingly. Therefore, the decoding method and the decoding device can increase the decoding speed and decoding performance of the receiver.

The above-mentioned descriptions represent merely the exemplary embodiment of the present disclosure, without any intention to limit the present disclosure thereto.

## Claims

1. A decoding method, provided for a decoding device of a specific error-correction coding system, wherein an encoding device of the specific error-correction coding system has m registers, and an initial state of the m registers is set as the values of least m significant bits of control information, the decoding method is **characterized in**, comprising:
receiving a symbol sequence output from the encoding device (FIG. 1, S101);
performing a Viterbi algorithm on the symbol sequence to generate a decoding sequence (FIG. 1, S103); and
based on the decoding sequence, updating a path merit of a state corresponding to the decoding sequence, and/or updating path merits of other states not corresponding to the decoding sequence (FIG. 1, S105).

2. The decoding method of claim 1, wherein a specific error-correction code used in the specific error-correction coding system is a convolution code.

3. The decoding method of claim 1, wherein the values of the least m significant bits of the control information are values of least m significant bits of a header in a frame.

4. The decoding method of claim 1, wherein the decoding device is a Viterbi decoding device.

5. The decoding method of claim 1, which is **characterized in**, further comprising: updating a probability of each of the states based on the decoding sequence, and then updating the path merits of the states based on the updated probabilities.

6. The decoding method of claim 5, wherein updating the probability of each of the states comprising: increasing the probability of the state corresponding to the decoding sequence and decreasing the probabilities of the other states not corresponding to the decoding sequence.

7. The decoding method of claim 6, wherein decreasing the path merit of the state corresponding to the decoding sequence based on the probability of the state corresponding to the decoding sequence, and increasing the path merits of the other states not corresponding to the decoding sequence based on the probabilities of the other states not corresponding to the decoding sequence.

8. A decoding device (FIG. 4, 4), for receiving a symbol sequence output from an encoding device of a specific error-correction coding system, wherein the encoding device has m registers, and an initial state of the m registers is set as the values of least m significant bits of control information, the decoding method is **characterized in**, comprising one or multiple circuits configured for:
a Viterbi algorithm calculation module (FIG. 4, 41), used to perform a Viterbi algorithm on the symbol sequence to generate a decoding sequence; and
a path merit assignment module (FIG. 4, 43), used to update a path merit of a state corresponding to the decoding sequence based on the decoding sequence, and/or update path merits of other states not corresponding to the decoding sequence based on the decoding sequence.

9. The decoding device of claim 8, wherein a specific error-correction code used in the specific error-correction coding system is a convolution code.

10. The decoding device of claim 8, wherein the values of the least m significant bits of the control information are values of least m significant bits of a header in a frame.

11. The decoding device of claim 8, wherein the decoding device is a Viterbi decoding device.

12. The decoding device of claim 8, which is **characterized in**, the path merit assignment module comprising:
a probability updating unit (FIG. 4, 431), used to update a probability of each of the states based on the decoding sequence; and
a path merit updating unit (FIG. 4, 433), used to update the path merits of the states based on the updated probabilities.

13. The decoding device of claim 12, wherein the probability updating unit increases the probability of the state corresponding to the decoding sequence and decreases the probabilities of the other states not corresponding to the decoding sequence.

14. The decoding device of claim 13, wherein the path merit updating unit decreases the path merit of the state corresponding to the decoding sequence based on the probability of the state corresponding to the decoding sequence, and increases the path merits of the other states not corresponding to the decoding sequence based on the probabilities of the other states not corresponding to the decoding sequence.

## Amended claims

### Amended claims in accordance with Rule 137(2) EPC.

**1.** A decoding method, provided for a decoding device of a specific error-correction coding system, wherein an encoding device of the specific error-correction coding system has m registers, and an initial state of the m registers is set as the values of least m significant bits of control information associated with a physic layer frame, wherein the control information is located in a header of the physic layer frame, and the physic layer frame is encoded by the encoding device to generate a symbol sequence, the decoding method is **characterized in**, comprising:
receiving the symbol sequence output from the encoding device (FIG. 1, S101);
performing a Viterbi algorithm on the symbol sequence to generate a decoding sequence (FIG. 1, S103); and
based on the values of least m significant bits of the header of the decoding sequence, updating a path metric of a state corresponding to the decoding sequence, and/or updating path metrics of other states not corresponding to the decoding sequence (FIG. 1, S105).

**2.** The decoding method of claim 1, wherein a specific error-correction code used in the specific error-correction coding system is a convolution code.

**3.** The decoding method of claim 1, wherein the values of the least m significant bits of the control information are values of least m significant bits of the header in the physic layer frame.

**4.** The decoding method of claim 1, wherein the decoding device is a Viterbi decoding device.

**5.** The decoding method of claim 1, which is **characterized in**, further comprising: updating a probability of each of the states based on the values of least m significant bits of the header of the decoding sequence, and then updating the path metrics of the states based on the updated probabilities.

**6.** The decoding method of claim 5, wherein updating the probability of each of the states comprising: increasing the probability of the state corresponding to the decoding sequence and decreasing the probabilities of the other states not corresponding to the decoding sequence.

**7.** The decoding method of claim 6, wherein decreasing the path metric of the state corresponding to the decoding sequence based on the probability of the state corresponding to the decoding sequence, and increasing the path metrics of the other states not corresponding to the decoding sequence based on the probabilities of the other states not corresponding to the decoding sequence.

**8.** A decoding device (FIG. 4, 4), for receiving a symbol sequence output from an encoding device of a specific error-correction coding system, wherein the encoding device has m registers, and an initial state of the m registers is set as the values of least m significant bits of control information associated with a physic layer frame, wherein the control information is located in a header of the physic layer frame, and the physic layer frame is encoded by the encoding device to generate the symbol sequence, the decoding method is **characterized in**, comprising one or multiple circuits configured for:
a Viterbi algorithm calculation module (FIG. 4, 41), used to perform a Viterbi algorithm on the symbol sequence to generate a decoding decoding sequence.

**14.** The decoding device of claim 13, wherein the path metric updating unit decreases the path metric of the state corresponding to the decoding sequence based on the probability of the state corresponding to the decoding sequence, and increases the path metrics of the other states not corresponding to the decoding sequence based on the probabilities of the other states not corresponding to the decoding sequence.
